# EUROPEAN PATENT APPLICATION

(11) **EP 4 653 506 A1**
(43) Date of publication of application: **26.11.2025**
(21) Application number: 25174396.9
(22) Date of filing: 10.12.2021
(51) Int. Cl.: C09G 1/02, H01L 21/321, C09K 3/14

(54) **CHEMICAL MECHANICAL POLISHING COMPOSITIONS AND METHODS OF USE THEREOF**

(30) Priority: 21.12.2020 US 202063128415 P
(62) Divisional of application: 21911884.1
(71) Applicant: FUJIFILM Electronic Materials U.S.A, Inc., North Kingstown RI 02852 (US)
(72) Inventor: CHENG, Qingmin, Mesa, AZ 85210 (US); HU, Bin, Chandler, AZ 85248 (US); LIANG, Yannan, Gilbert, AZ 85234 (US); WEN, Liqing (Richard), Mesa, AZ 85215 (US)
(74) Representative: dompatent

(57) **Abstract**

The present disclosure provides a composition that can polish substrates containing multiple metals, for example cobalt and tungsten. The compositions can provide favorable removable rates of those metals while mitigating corrosion, and show favorable polishing selectivity ratios with respect to other materials. The polishing composition of the present disclosure can include at least one abrasive, at least one organic acid, at least one anionic surfactant, at least one first amine compound comprising an alkylamine having a 6-24 carbon alkyl chain, at least one azole containing compound, an optional second amine compound comprising an aminoalcohol, an aqueous solvent, and, optionally a pH adjuster.

## Description

### BACKGROUND OF THE DISCLOSURE

### 1. Field of the Disclosure

The present disclosure relates to chemical mechanical polishing compositions. In particular, the present disclosure relates to polishing compositions that balances required polishing performance characteristics of cobalt and other substances used in the field, such as tungsten.

### 2. Discussion of the Related Art

The semiconductor industry is continually driven to improve chip performance by further miniaturization of devices by process, materials, and integration innovations. Earlier materials innovations included the introduction of copper, replacing aluminum as the conductive material in the interconnect structure, and the use of tantalum (Ta)/tantalum nitride (TaN) (or titanium (Ti)/titanium nitride (TiN)) as diffusion barrier to separate the Cu conductive material from the non-conductive/insulator dielectric material. Copper (Cu) was chosen as the interconnect material because of its low resistivity and superior resistance against electro-migration.

However, as the features of newer generation chips shrink, the multilayer Cu/barrier/dielectric stacks have to be thinner and more conformal to maintain effective interconnect resistivity in Back End of Line (BEOL). The thinner Cu and the Ta/TaN barrier film schemes present problems with resistivity and flexibility in deposition. For example, with smaller dimensions and advanced manufacturing nodes, resistivity is proceeding to be exponentially worse and improvements in transistor circuit speed (at Front End of Line (FEOL)) are being cut in half by the delay coming from the conductive Cu/Barrier wiring (BEOL). Cobalt (Co) has emerged as a leading candidate for use as a liner material, a barrier layer, as well as a conductive layer. Furthermore, cobalt is also being investigated as a replacement for tungsten (W) metal in multiple applications such as W metal contacts, plugs, vias, and gate materials.

Many currently available CMP slurries were specifically designed to remove materials more common in older chip designs, such as the aforementioned copper and tungsten. Certain components in these older CMP slurries may cause deleterious and unacceptable defects in cobalt, since cobalt is more susceptible to chemical corrosion. As a result, when using copper polishing slurries on cobalt layers, unacceptable corrosion, wafer topography, and removal rate selectivity often occur.

While cobalt is still used in conjunction with other metals (e.g., Cu and/or W), with the increasing use of cobalt (Co) as a metal component in semiconductor fabrication, there is a market need for CMP slurries that can effectively polish a dielectric component or a barrier component on Co-containing surfaces without significant metal corrosion.

### SUMMARY OF THE DISCLOSURE

This summary is provided to introduce a selection of concepts that are further described below in the detailed description. This summary is not intended to identify key or essential features of the claimed subject matter, nor is it intended to be used as an aid in limiting the scope of the claimed subject matter.

As defined herein, unless otherwise noted, all percentages expressed should be understood to be percentages by weight to the total weight of the chemical mechanical polishing composition. In addition, all stated ranges include the disclosed range and any subranges thereof. For example, a range of "from 0.1% to 1% by weight" includes the range 0.1 - 1, as well as any subranges thereof, such as 0.2-0.9, 0.5-1, 0.1-0.5, etc. A range of "6 to 24 carbons" includes 6-24 carbons, 8-20 carbons, 6-12 carbons, 10-24 carbons, etc.

In one aspect, embodiments disclosed herein relate to polishing compositions including at least one abrasive, at least one organic acid, at least one azole containing compound, a first amine compound comprising a 6-24 carbon alkyl chain, at least one anionic surfactant; and an aqueous solvent, optionally, a pH adjuster..

In another aspect, embodiments disclosed herein relate to methods of polishing substrates using the polishing compositions described herein. Other aspects and advantages of the claimed subject matter will be apparent from the following description and the appended claims.

### DETAILED DESCRIPTION OF THE DISCLOSURE

Embodiments disclosed herein relate generally to compositions and methods of using said compositions to polish substrates that include at least a cobalt portion and a tungsten portion. Further, embodiments disclosed herein relate to compositions and methods of using said compositions to polish substrates that include at least cobalt, tungsten, and dielectric (TEOS, SiN, low-k, etc.) portions.

With the introduction of cobalt (Co) as a barrier layer, conductive layer, and/or W replacement, there is a market need for CMP slurries that can polish Co at effective material removal rates without experiencing significant Co corrosion (i.e., having a moderate Co removal rate) and have a range of selectivities in polishing rates of other metals and metal nitrides or oxides (Cu, W, Ti, TiN, Ta TaN, Ta₂O₅, TiO₂, Ru, ZrO₂, HfO₂, etc.), and dielectric films (SiN, silicon oxide, Poly-Si, low k dielectrics (e.g., carbon doped silicon oxides), etc.). For example, after an aggressive bulk polishing step where large amounts of materials are removed, it is often desirable to perform a buffing polish step in order to obtain the desired surface topography. In some embodiments, the composition used for the buffing polish will remove dielectric materials and metals (e.g., TEOS, SiN, and Co) at a lower rate than what occurs during a bulk polishing step or at approximately the same removal rate for each component (e.g., within 10% or within 5%) in order to obtain the desired surface topography. Because Co is more chemically reactive than Cu and other noble metals, Co corrosion prevention is very challenging in advanced nodes composition design. Current metal polishing slurries are ill-equipped to polish surfaces that include Co as they suffer from Co corrosion issues during the CMP process. In addition, it is generally desirable to remove a certain amount of Co during polishing to form a smooth surface in a patterned semiconductor substrate for subsequent manufacturing processes.

Further, advanced nodes often utilize substrates with multiple metals (e.g., Co and W), and thus, considerations must also be made when formulating a polishing composition to prevent excessive corrosion of each metal. Corrosion occurs to different degrees for each metal when placed in they are placed in the same chemical environment. For example, generally cobalt is more easily corroded under low pH conditions than tungsten and the opposite is true under high pH conditions. Similar considerations are also applicable for chemical additives (i.e., some chemical additives potentially corrode, or prevent corrosion, one metal more than a different metal).

In one or more embodiments, the polishing composition of the present disclosure includes: at least one abrasive; at least one organic acid; at least one anionic surfactant; at least one first amine compound comprising an alkylamine having a 6-24 carbon alkyl chain; at least one azole containing compound; a second amine compound comprising an aminoalcohol; an aqueous solvent; and, optionally a pH adjuster.

In one or more embodiments, the polishing composition of the present disclosure includes: at least one abrasive; at least one organic acid: optionally at least one anionic surfactant; at least one first amine compound comprising an alkylamine having a 6-24 carbon alkyl chain; at least one azole containing compound; at least one second amine compound comprising an aminoalcohol; an aqueous solvent; and, optionally a pH adjuster.

In one or more embodiments, the polishing composition of the present disclosure includes: at least one abrasive; at least one organic acid; at least one anionic surfactant; at least one first amine compound comprising an alkylamine having a 6-24 carbon alkyl chain; at least one azole containing compound; optionally at least one second amine compound comprising an aminoalcohol; an aqueous solvent; and, optionally a pH adjuster.

In one or more embodiments, a polishing composition according to the present disclosure can include: from about 0.1% to about 25% by weight of abrasive; about 0.001% to about 1% by weight of organic acid; about 0.001% to about 0.5% by weight of anionic surfactant; about 0.0005% to about 0.5% by weight of an alkylamine having a 6-24 carbon alkyl chain; about 0.001% to about 0.5% by weight of an azole containing compound; optionally about 0.001% to about 0.5% by weight of a second amine compound comprising an aminoalcohol; and the remaining percent (e.g., about 70-99% by weight) of an aqueous solvent.

In one or more embodiments, the present disclosure provides a concentrated polishing composition that can be diluted with water prior to use by up to a factor of two, or up to a factor of three, or up to a factor of four, or up to a factor of six, or up to a factor of eight, or up to a factor of ten. In other embodiments, the present disclosure provides a point-of-use (POU) polishing composition for use on cobalt and tungsten containing substrates, comprising the above-described polishing composition, water, and optionally an oxidizer.

In one or more embodiments, a POU polishing composition according to the present disclosure can include: from about 0.1% to about 12% by weight of abrasive; about 0.001% to about 0.5% by weight of organic acid; about 0.001% to about 0.05% by weight of an anionic surfactant; about 0.0005% to about 0.05% by weight of a first amine compound comprising an alkylamine having a 6-24 carbon alkyl chain; about 0.001% to about 0.1% by weight of an azole containing compound; optionally about 0.001% to about 0.05% by weight of a second amine compound comprising an aminoalcohol; and the remaining percent (e.g., about 70-99% by weight) of an aqueous solvent.

In one or more embodiments, a concentrated polishing composition according to the present disclosure can include: from about 1% to about 25% by weight of abrasive; about 0.01% to about 1% by weight of organic acid; about 0.01% to about 0.5% by weight of anionic surfactant, about 0.005% to about 0.5% by weight of an alkylamine having a 6-24 carbon alkyl chain; about 0.01% to about 0.5% by weight of an azole containing compound; optionally about 0.01% to about 0.5% by weight of an aminoalcohol; and the remaining percent (e.g., about 70-99% by weight) of an aqueous solvent.

In one or more embodiments, the polishing compositions described herein can include at least one (e.g., two or three) abrasive. In one or more embodiments, the at least one abrasive is selected from the group consisting of cationic abrasives, substantially neutral abrasives, and anionic abrasives. In one or more embodiments, the at least one abrasive is selected from the group consisting of alumina, silica, titania, ceria, zirconia, co-formed products thereof (i.e., co-formed products of alumina, silica, titania, ceria, or zirconia), coated abrasives, surface modified abrasives, and mixtures thereof. In some embodiments, the at least one abrasive does not include ceria. In some embodiments, the at least one abrasive has a high purity, and can have less than about 100 ppm of alcohol, less than about 100 ppm of ammonia, and less than about 100 ppb of an alkali cation such as sodium cation. The abrasive can be present in an amount of from about 0.01% to about 12% (e.g., from about 0.5% to about 10%), based on the total weight of a POU polishing composition, or any subranges thereof.

In one or more embodiments, the abrasive is a silica-based abrasive, such as one selected from the group consisting of colloidal silica, fumed silica, and mixtures thereof. In one or more embodiments, the abrasive can be surface modified with organic groups and/or non-siliceous inorganic groups. For example, the cationic abrasive can include terminal groups of formula (I):

-Oₘ-X-(CH₂)ₙ-Y (I),

in which m is an integer from 1 to 3; n is an integer from 1 to 10; X is Al, Si, Ti, Ce, or Zr; and Y is a cationic amino or thiol group. As another example, the anionic abrasive can include terminal groups of formula (I):

-Oₘ-X-(CH₂)ₙ-Y (I),

in which m is an integer from 1 to 3; n is an integer from 1 to 10; X is Al, Si, Ti, Ce, or Zr; and Y is an acid group.

In one or more embodiments, the abrasive described herein can have a mean particle size of from at least about 1 nm (e.g., at least about 5 nm, at least about 10 nm, at least about 20 nm, at least about 40 nm, at least about 50 nm, at least about 60 nm, at least about 80 nm, or at least about 100 nm) to at most about 1000 nm (e.g., at most about 800 nm, at most about 600 nm, at most about 500 nm, at most about 400 nm, or at most about 200 nm). As used herein, the mean particle size (MPS) is determined by dynamic light scattering techniques.

In some embodiments, the at least one abrasive is present in an amount of from at least about 0.1% (e.g., at least about 0.5%, at least about 1%, at least about 2%, at least about 4%, at least about 5%, at least about 10%, at least about 12%, at least about 15%, or at least about 20%) by weight to at most about 25% (e.g., at most about 20%, at most about 18, at most about 15%, at most about 12%, at most about 10%, or at most about 5%) by weight of the polishing composition described herein.

In one or more embodiments, the polishing compositions described herein include at least one (e.g., two or three) organic acid or a salt of the organic acid. In one or more embodiments, the organic acid (or salts thereof) can be selected from the group consisting of a carboxylic acid, an amino acid, an organic sulfonic acid, an organic phosphonic acid, or mixtures thereof. In some embodiments, the organic acid can be a carboxylic acid that includes one or more (e.g., two, three, or four) carboxylic acid groups, such as a dicarboxylic acid or a tricarboxylic acid. In some embodiments, the organic acid or salts thereof can be an amino acid including a carboxylic acid group. In one or more embodiments, the organic acid is selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic acid, m-xylene-4-sulfonic acid, poly(4-styrenesulfonic acid), polyanetholesulfonic acid, p-toluenesulfonic acid, trifluoromethane-sulfonic acid, ethyl phosphoric acid, cyanoethyl phosphoric acid, phenyl phosphoric acid, vinyl phosphoric acid, poly(vinylphosphonic acid), 1-hydroxyethane-1,1-diphosphonic acid, nitrilotri(methylphosphonic acid), diethylenetriaminepentakis (methylphosphonic acid), N,N,N'N'-ethylenediaminetetrakis(methylene phosphonic acid), n-hexylphosphonic acid, benzylphosphonic acid, phenylphosphonic acid, salts thereof, and mixtures thereof. Without wishing to be bound by theory, it is surprising that the organic acid (such as those described above) can be used as a low etching complexing agent for cobalt metal, while also facilitating pH adjustment.

In some embodiments, the at least one organic acid is in an amount of from at least about 0.001% (e.g., at least about 0.003%, at least about 0.005%, at least about 0.01%, at least about 0.03%, at least about 0.05%, at least about 0.075% at least about 0.1%, at least about 0.25%, at least about 0.5%, or at least about 0.75%) by weight to at most about 1% (e.g., at most about 0.75%, at most about 0.5%, at most about 0.25%, at most about 0.1%, at most about 0.075%, at most about 0.05%, at most about 0.025%, at most about 0.005%, or at most 0.003%) by weight of the polishing composition described herein. In embodiments where more than one organic acid is included in the composition, the above ranges may apply to each organic acid independently, or to the combined amount of organic acid within the polishing composition.

In one or more embodiments, the polishing composition includes an anionic surfactant. In one or more embodiments, the anionic surfactant is selected from the group consisting of carboxylic acid salts, sulfonic acid salts, sulfate salts, phosphate salts or mixtures thereof. The carboxylic acid salts are not particularly limited, but specific examples thereof include fatty acid salts (e.g., soaps) and alkyl ether carboxylic acid salts. Examples of the sulfonic acid salts include alkylbenzenesulfonic acid salts (e.g., dodecylbenzenesulfonic acid), alkylnaphthalenesulfonic acid salts, and α-olefin sulfonic acid salts. The sulfate salts are not particularly limited, but specific examples thereof include higher alcohol sulfate salts and alkyl sulfate salts. The phosphates are not particularly limited, but specific examples thereof include alkyl phosphates and alkyl ester phosphates. In one or more embodiments, the anionic surfactant comprises a sulphonate group, also referred to as a sulfonic acid group. In one or more embodiments, the at least one anionic surfactant is selected from the group consisting of an alkyl sulphonate, an alkylaryl sulphonate, a polyoxyethylene alkyl ether sulphonate, a polyoxyethylene aryl alkyl ether sulphonate, a polyoxyethylene nonylaryl ether sulphonate, a polyoxyethylene nonylphenyl ether sulphonate, and mixtures thereof. Without wishing to be bound by theory, it is surprising that an anionic surfactant (such as those described above) can function as a cobalt corrosion inhibitor in the polishing composition described herein to reduce or minimize the removal rate of cobalt in a semiconductor substrate.

In some embodiments, the anionic surfactant is in an amount of from at least about 0.001% (e.g., at least about 0.002%, at least about 0.005%, at least about 0.01%, at least about 0.02%, at least about 0.05%, at least about 0.1%, or at least about 0.2%) by weight to at most about 0.5% (e.g., at most about 0.4%, at most about 0.2%, at most about 0.1%, at most about 0.08%, at most about 0.05%, at most about 0.02%, at most about 0.0075%, or at most about 0.005%) by weight of the polishing composition described herein.

In one or more embodiments, the at least one azole is selected from the group consisting of heterocyclic azoles, substituted or unsubstituted triazoles (e.g., benzotriazoles), substituted or unsubstituted tetrazoles, substituted or unsubstituted diazoles (e.g., imidazoles, benzimidazoles, thiadiazoles, and pyrazoles), and substituted or unsubstituted benzothiazoles. Herein, a substituted diazole, triazole, or tetrazole refers to a product obtained by substitution of one or two or more hydrogen atoms in the diazole, triazole, or tetrazole with, for example, a carboxyl group, an alkyl group (e.g., a methyl, ethyl, propyl, butyl, pentyl, or hexyl group), a halogen group (e.g., F, Cl, Br, or I), an amino group, or a hydroxyl group. In one or more embodiments, the azole compound can be selected from the group consisting of tetrazole, benzotriazole, tolyltriazole, methyl benzotriazole (e.g., 1-methyl benzotriazole, 4-methyl benzotriazole, and 5-methyl benzotriazole), ethyl benzotriazole (e.g., 1-ethyl benzotriazole), propyl benzotriazole (e.g., 1-propyl benzotriazole), butyl benzotriazole (e.g., 1-butyl benzotriazole and 5-butyl benzotriazole), pentyl benzotriazole (e.g., 1-pentyl benzotriazole), hexyl benzotriazole (e.g., 1-hexyl benzotriazole and 5-hexyl benzotriazole), dimethyl benzotriazole (e.g., 5,6-dimethyl benzotriazole), chloro benzotriazole (e.g., 5-chloro benzotriazole), dichloro benzotriazole (e.g., 5,6-dichloro benzotriazole), chloromethyl benzotriazole (e.g., 1-(chloromethyl)-1-H-benzotriazole), chloroethyl benzotriazole, phenyl benzotriazole, benzyl benzotriazole, aminotriazole, aminobenzimidazole, pyrazole, imidazole, aminotetrazole, adenine, benzimidazole, thiabendazole, 1,2,3-triazole, 1,2,4-triazole, 1-hydroxybenzotriazole, 2-methylbenzothiazole, 2-aminobenzimidazole, 2-amino-5-ethyl-1,3,4-thiadiazole, 3,5-diamino-1,2,4-triazole, 3-amino-5-methylpyrazole, 4-amino-4H-1,2,4-triazole, aminotetrazole, tetrazole, phenyltetrazole, phenyl-tetrazole-5-thiol, and combinations thereof. Without wishing to be bound by theory, it is believed that the azole compounds can be used as a corrosion inhibitor in the polishing compositions described herein to reduce the removal of certain materials (e.g., metals or dielectric materials) during the polishing process.

In some embodiments, the at least one azole is in an amount of from at least about 0.001% (e.g., at least about 0.002%, at least about 0.005%, at least about 0.01%, at least about 0.02%, at least about 0.05%, at least about 0.1%, or at least about 0.2%) by weight to at most about 0.5% (e.g., at most about 0.4%, at most about 0.2%, at most about 0.1%, at most about 0.08%, at most about 0.05%, at most about 0.02%, at most about 0.0075%, or at most about 0.005%) by weight of the polishing composition described herein.

In some embodiments, the polishing compositions described herein include at least one (e.g., two or three) first amine compound. In one or more embodiments, the first amine compound can be an alkylamine compound that has at least one (e.g., two or three) alkyl chain that includes between 6 and 24 (i.e., 6, 7, 8, 9, 10, 11, 12, 13, 14, 15, 16, 17, 18, 19, 20, 21, 22, 23, or 24) carbons. In one or more embodiments, the alkyl chain can be a linear, branched, or cyclic alkyl group. In one or more embodiments, the alkylamine compound can be a primary, secondary, tertiary, or cyclic compound. In one or more embodiments, the alkylamine compound can be an alkoxylated amine (e.g., include ethoxylate and/or propoxylate groups). In one or more embodiments, the alkoxylated amine can include from 2 to 100 ethoxylate and/or propoxylate groups. In some embodiments, the at least one alkylamine compound has an alkyl chain that includes between 6 and 18 carbons. In some embodiments, the alkylamine is selected from the group consisting of hexylamine, octylamine, decylamine, dodecylamine, tetradecylamine, pentadecylamine, hexadecylamine, octadecylamine, cyclohexylamine, dicyclohexylamine, dipropylamine, or mixtures thereof. Without wishing to be bound by theory, it is surprising that the alkylamine compounds described above can significantly reduce or minimize the corrosion of tungsten in a semiconductor substrate.

In some embodiments, the first amine compound is in an amount of from at least about 0.0005% (e.g., at least about 0.001%, at least about 0.002%, at least about 0.005%, at least about 0.01%, at least about 0.02%, at least about 0.05%, at least about 0.1%, or at least about 0.2%) by weight to at most about 0.5% (e.g., at most about 0.4%, at most about 0.2%, at most about 0.1%, at most about 0.08%, at most about 0.05%, at most about 0.02%, at most about 0.0075%, or at most about 0.005%) by weight of the polishing composition described herein.

In some embodiments, the polishing compositions described herein include a second amine compound that includes at least one (e.g., two or three) aminoalcohol. In one or more embodiments, the second amine compound is a β-hydroxyl-alkylamine or a derivative thereof. In one or more embodiments, the second amine compound is selected from the group consisting of ethanolamine, diethanolamine, 2-amino-3-hexanol, 2-amino-2-methyl-3-hexanol, 2-amino-2-methyl-3-heptanol, 2-amino-4-ethyl-3-octanol, 2-amino-3-heptanol,2-amino-1-phenylbutanol, 3-Amino-4-octanol, 2-Dimethylamino-2-methyl-1-propanol, 2-Amino-1-butanol, 2-amino-2-ethylpropanediol,2-Amino-2-methyl-1-propanol, 2-Methylamino-2-methyl-1-propanol, 1-amino-2-propanol, bis(2-hydroxypropyl)amine, tris(2-hydroxypropyl)amine, bis(2-hydroxyethyl)amine, tris(2-hydroxyethyl)amine, 2-(2-aminoethoxy)ethanol, or mixtures thereof.

In some embodiments, the second amine compound is included in the polishing composition in an amount from at least about 0.001% (e.g., at least about 0.0025, at least about 0.005%, at least about 0.0075%, at least about 0.01%, at least about 0.025%, at least about 0.05%, at least about 0.1%, or at least about 0.25%) by weight to at most about 0.5% % (e.g., at most about 0.4%, at most about 0.2%, at most about 0.1%, at most about 0.08%, at most about 0.05%, at most about 0.02%, or at most about 0.0075%) by weight of the polishing composition described herein.

In one or more embodiments, a polishing composition may further include a pH adjuster. In one or more embodiments, the pH adjuster is selected from the group consisting of ammonium hydroxide, sodium hydroxide, potassium hydroxide, cesium hydroxide, monoethanolamine, diethanolamine, triethanolamine, methylethanolamine, methyldiethanolamine tetrabutylammonium hydroxide, tetrapropylammonium hydroxide, tetraethylammonium hydroxide, tetramethylammonium hydroxide, ethyltrimethylammonium hydroxide, diethyldimethylammonium hydroxide, dimethyldipropylammonium hydroxide, benzyltrimethylammonium hydroxide, tris(2-hydroxyethyl)methylammonium hydroxide, choline hydroxide, and any combinations thereof.

In some embodiments, the at least one pH adjuster, when included in the composition, is in an amount of from at least about 0.005% (e.g., at least about 0.0075%, at least about 0.01%, at least about 0.025, at least about 0.05%, at least about 0.1%, at least about 0.5%, at least about 1%, at least about 1.5%, at least about 2%, at least about 2.5%, at least about 4%, or at least about 4.5%) by weight to at most about 10% (e.g., at most about 9.5%, at most about 9%, at most about 8.5%, at most about 8%, at most about 7.5%, at most about 7%, at most about 6.5%, at most about 6%, at most about 5.5%, at most about 5%, at most about 5%, at most about 4.5%, at most about 4%, at most about 3.5%, at most about 3%, at most about 2.5%, at most about 2%, at most about 1.5%, at most about 1%, at most about 0.5%, at most about 0.2%, at most about 0.1%, at most about 0.05%) by weight of the polishing composition described herein.

In some embodiments, the pH value of the polishing composition can range from at least about 1 (e.g., at least about 1.5, at least about 2, at least about 2.5, at least about 3, at least about 3.5, at least about 4, at least about 4.5, at least about 5, at least about 5.5, or at least about 6) to at most about 7 (e.g., at most about 6.5, at most about 6, at most about 5.5, at most about 5, at most about 4.5, at most about 4, at least about 3.5, at most about 3, at most about 2.5, or at most about 2). Without wishing to be bound by theory, it is believed that a polishing composition having a pH higher than 7 would significantly increase tungsten removal rate and corrosion, and a polishing composition having a pH lower than 1 can affect the stability of the suspended abrasive and would significantly increase the roughness and decrease the overall quality of a film polished by such a composition. In order to obtain the desired pH, the relative concentrations of the ingredients in the polishing compositions described herein can be adjusted.

An optional oxidizer can be added when diluting a concentrated composition to form a POU composition. The oxidizer can be selected from the group consisting of hydrogen peroxide, ammonium persulfate, silver nitrate (AgNO3), ferric nitrates or chlorides, per acids or salts, ozone water, potassium ferricyanide, potassium dichromate, potassium iodate, potassium bromate, potassium periodate, periodic acid, vanadium trioxide, hypochlorous acid, sodium hypochlorite, potassium hypochlorite, calcium hypochlorite, magnesium hypochlorite, ferric nitrate, potassium permanganate, other inorganic or organic peroxides, and mixtures thereof. In one embodiment, the oxidizer is hydrogen peroxide. In one or more embodiments, there is no oxidizer in the polishing compositions of the present disclosure.

In some embodiments, the oxidizer is in an amount of from at least about 0.01% (e.g., at least about 0.05%, at least about 0.1%, at least about 0.2%, at least about 0.4%, at least about 0.5%, at least about 1%, at least about 1.5%, at least about 2%, at least about 2.5%, at least about 3%, at least about 3.5%, at least about 4%, or at least about 4.5%) by weight to at most about 5% (e.g., at most about 4.5%, at most about 4%, at most about 3.5%, at most about 3%, at most about 2.5%, at most about 2%, at most about 1.5%, at most about 1%, at most about 0.5%, or at most about 0.1%) by weight of the polishing composition described herein. In some embodiments, the oxidizer may reduce the shelf life of a polishing composition. In such embodiments, the oxidizer can be added to the polish composition at the point of use right before polishing.

In some embodiments, the polishing composition described herein can include a solvent (e.g., a primary solvent), such as water. In some embodiments, the solvent (e.g., water) is in an amount of from at least about 20% (e.g., at least about 25%, at least about 30%, at least about 35%, at least about 40%, at least about 45%, at least about 50%, at least about 55%, at least about 60%, at least about 65%, at least about 70%, at least about 75%, at least about 80%, at least about 85%, at least about 90%, at least about 92%, at least about 94%, at least about 95%, or at least about 97%) by weight to at most about 99% (e.g., at most about 98%, at most about 96%, at most about 94%, at most about 92%, at most about 90%, at most about 85%, at most about 80%, at most about 75%, at most about 70%, or at most about 65%) by weight of the polishing composition described herein.

In one or more embodiments, an optional secondary solvent (e.g., an organic solvent) can be used in the polish composition (e.g., the POU or concentrated polishing composition) of the present disclosure, which can help with the dissolution of the azole-containing corrosion inhibitor. In one or more embodiments, the secondary solvent can be one or more alcohols, alkylene glycols, or alkylene glycol ethers. In one or more embodiments, the secondary solvent comprises one or more solvents selected from the group consisting of ethanol, 1-propanol, 2-propanol, n-butanol, propylene glycol, 2-methoxyethanol, 2-ethoxyethanol, propylene glycol propyl ether, and ethylene glycol.

In some embodiments, the secondary solvent is in an amount of from at least about 0.005% (e.g., at least about 0.01%, at least about 0.02%, at least about 0.05%, at least about 0.1%, at least about 0.2%, at least about 0.4%, at least about 0.6%, at least about 0.8%, at least about 1%, at least about 3%, at least about 5%, or at least about 10%) by weight to at most about 15% (e.g., at most about 12%, at most about 10%, at most about 5%, at most about 3%, at most about 2%, at most about 1%, at most about 0.8%, at most about 0.6%, at most about 0.5%, or at most about 0.1%) by weight of the polishing composition described herein.

In one or more embodiments, the polishing composition described herein can be substantially free of one or more of certain ingredients, such as organic solvents, pH adjusting agents (e.g., di- or tri-carboxylic acids), quaternary ammonium compounds (e.g., salts or hydroxides), amines, alkali bases (such as alkali hydroxides), fluorine containing compounds (e.g., fluoride compounds or fluorinated compounds (such as polymers/surfactants)), silicon-containing compounds such as silanes (e.g., alkoxysilanes), imines (e.g., amidines such as 1,8-diazabicyclo[5.4.0]-7-undecene (DBU) and 1,5-diazabicyclo[4.3.0]non-5-ene (DBN)), salts (e.g., halide salts or metal salts), polymers (e.g., cationic or anionic polymers), surfactants (e.g., cationic surfactants, anionic surfactants, or non-ionic surfactants), plasticizers, oxidizing agents (e.g., H₂O₂ or periodic acid), corrosion inhibitors (e.g., chlorinated azoles or non-azole corrosion inhibitors), electrolytes (e.g., polyelectrolytes), and/or certain abrasives (e.g., ceria abrasives, non-ionic abrasives, surface modified abrasives, or negatively/positively charged abrasive). The halide salts that can be excluded from the polishing compositions include alkali metal halides (e.g., sodium halides or potassium halides) or ammonium halides (e.g., ammonium chloride), and can be fluorides, chlorides, bromides, or iodides. As used herein, an ingredient that is "substantially free" from a polishing composition refers to an ingredient that is not intentionally added into the polishing composition. In some embodiments, the polishing composition described herein can have at most about 1000 ppm (e.g., at most about 500 ppm, at most about 250 ppm, at most about 100 ppm, at most about 50 ppm, at most about 10 ppm, or at most about 1 ppm) of one or more of the above ingredients that are substantially free from the polishing composition. In some embodiments, the polishing compositions described herein can be completely free of one or more of the above ingredients.

The present disclosure also contemplates a method of using any of the above-described concentrates or POU slurries. With the concentrate, the method can comprise the steps of diluting the concentrate to form the POU polishing composition, and then contacting a substrate surface at least partially comprising cobalt with the POU polishing composition and bringing a pad (e.g., a polishing pad) into contact with the surface of the substrate and moving the pad in relation to the substrate. With the POU polishing composition, the method comprises the step of contacting the substrate surface at least partially comprising cobalt with the polishing composition and bringing a pad (e.g., a polishing pad) into contact with the surface of the substrate and moving the pad in relation to the substrate. In one or more embodiments, the surface contacted with the polishing composition may also include tungsten.

In one or more embodiments, this disclosure features a polishing method that can include applying a polishing composition according to the present disclosure to a substrate (e.g., a wafer) having at least cobalt on a surface of the substrate; and bringing a pad into contact with the surface of the substrate and moving the pad in relation to the substrate. In some embodiments, when the substrate includes at least one or more of silicon oxides (e.g., TEOS), silicon nitrides (e.g., SiN), and/or barrier materials (e.g., Ta, TaN, Ti, or TiN), the above method can remove at least a portion of these materials at about the same rate, or faster than, it removes cobalt and/or tungsten. For example, in one or more embodiments, polishing compositions of the present disclosure have a difference in polish rates between TEOS/SiN and Co of less than about 20%, less than about 15%, less than about 10%, or less than about 5%. In one or more embodiments, the polishing composition may have a polishing selectivity (i.e., the ratio between polishing rates) of silicon oxides (e.g., TEOS), silicon nitrides (e.g., SiN), and/or barrier materials (e.g., Ta, TaN, Ti, or TiN) to cobalt of at least about 1:1, at least about 1.5:1, at least about 2:1, at least about 2.5:1, at least about 3:1, at least about 3.5:1, at least about 4:1, at least about 4.5:1, at least about 5:1, at least about 5.5:1, at least about 6:1, at least about 6.5:1, at least about 7:1, at least about 7.5:1, at least about 8:1, at least about 8.5:1, at least about 9:1, at least about 9.5:1, or at least about 10:1. In one or more embodiments, the polishing composition may have a polishing selectivity (i.e., the ratio between polishing rates) of silicon nitrides (e.g., SiN), and/or barrier materials (e.g., Ta, TaN, Ti, or TiN) to silicon oxides (e.g., TEOS) of at least about 1:1, at least about1.5:1, at least about 2:1, at least about 2.5:1, at least about 3:1, at least about 3.5:1, at least about 4:1, at least about 4.5:1, at least about 5:1, at least about 5.5:1, at least about 6:1, at least about 6.5:1, at least about 7:1, at least about 7.5:1, at least about 8:1, at least about 8.5:1, at least about 9:1, at least about 9.5:1, or at least about 10:1. It is to be noted that the term "silicon oxide" described herein is expressly intended to include both un-doped and doped versions of silicon oxide. For example, in one or more embodiments, the silicon oxide can be doped with at least one dopant selected from carbon, nitrogen (for silicon oxide), oxygen, hydrogen, or any other known dopants for silicon oxide. Some examples of silicon oxide film types include TEOS (tetra-ethyl orthosilicate), SiOC, SiOCN, SiOCH, SiOH and SiON. In one or more embodiments, the removal rate for cobalt provided by a polishing composition according to the present disclosure may be between about 50-500 angstroms per minute when polishing a patterned or a blanket wafer. In one or more embodiments, the removal rate for tungsten provided by a polishing composition according to the present disclosure may be between about 0-100 angstroms per minute when polishing a patterned or a blanket wafer. In one or more embodiments, a polishing composition according to the present disclosure will have a static etch rate (SER) for a cobalt coupon incubated for five minutes at 60 °C of between about 0 Å/min to 50 Å/min (e.g. at least about 0.5 Å/min, at least about 1 Å/min, at least about 2.5 Å/min, at least about 5 Å/min, at least about 7.5 Å/min, or at least about 10 Å/min to at most about 45 Å/min, at most about 40 Å/min, at most about 35 Å/min, at most about 30 Å/min, at most about 25 Å/min, at most about 20 Å/min, at most about 15 Å/min, at most about 10 Å/min, or at most about 5 Å/min). In one or more embodiments, a polishing composition according to the present disclosure will have a static etch rate (SER) for a tungsten coupon incubated for five minutes at 60 °C of between about 0 Å/min to 20 Å/min (e.g. at least about 0.5 Å/min, at least about 1 Å/min, at least about 1.5 Å/min, at least about 2 Å/min, at least about 2.5 Å/min, or at least about 3 Å/min to at most about 15 Å/min, at most about 12.5 Å/min, at most about 10 Å/min, at most about 7.5 Å/min, at most about 5 Å/min, or at most about 2.5 Å/min).

In some embodiments, the method that uses a polishing composition described herein can further include producing a semiconductor device from the substrate treated by the polishing composition through one or more steps. For example, photolithography, ion implantation, dry/wet etching, plasma etching, deposition (e.g., PVD, CVD, ALD, ECD), wafer mounting, die cutting, packaging, and testing can be used to produce a semiconductor device from the substrate treated by the polishing composition described herein.

The specific examples below are to be construed as merely illustrative, and not limitative of the remainder of the disclosure in any way whatsoever. Without further elaboration, it is believed that one skilled in the art can, based on the description herein, utilize the present invention to its fullest extent.

### EXAMPLES

In these examples, the polishing was performed on 200 mm wafers using a Mirra polisher with a H804 pad and a composition flow rate of 175 mL/min.

The general compositions used in the examples below are shown in Table 1 below. The specifics details on the differences in the compositions tested will be explained in further detail when discussing the respective examples.

**Table 1**

| **Component** | **% By Weight of Composition** |
|---|---|
| pH adjuster (base) | 0.01-1 |
| Organic Acid | 0.01-1 |
| First Amine compound | 0.0005 - 0.5 (if used) |
| Azole-Containing Compound | 0.01-0.5 (if used) |
| Anionic Surfactant | 0.001-0.1 (if used) |
| Second Amine Compound | 0.001-0.1 (if used) |
| Organic Solvent | 0.025-1 |
| Abrasive (silica) | 0.1-12 |
| Solvent (DI Water) | 75-99 |
| pH | 2-7 |
| | |

### Example 1

The removal rate for a variety of materials was measured by polishing blanket wafers with compositions 1-3. Compositions 1-3 were identical except that (1) Composition 1 did not include an organic phosphonic acid, and (2) Compositions 2 and 3 included the same organic phosphonic acid in 0.3X and 2X concentration, respectively. Compositions 1-3 did not include the first amine compound, second amine compound, or the anionic surfactant. Compositions 1-3 did include an abrasive, an azole containing compound, an alkyl substituted benzotriazole, in a fixed concentration. The test results are summarized in Table 2 below.

**Table 2**

| | Comp. 1 | Comp. 2 | Comp. 3 |
|---|---|---|---|
| Organic Phosphonic Acid | None | 2X | 13.33X |
| Co RR (Å/min) | 936 | 522 | 337 |
| W RR (Å/min) | 32 | 22 | 25 |
| SiN RR (Å/min) | 286 | 154 | 138 |
| TEOS RR (Å/min) | 83 | 77 | 73 |

The results show that the organic phosphonic acid can effectively reduce the removal rate of cobalt and, to a lesser extent, SiN, with increasing amounts showing a larger reduction in removal rate.

### Example 2

The removal rate for a variety of materials was measured by polishing blanket wafers with compositions 4-10. Compositions 4-10 were identical except that (1) Composition 4 did not include an anionic surfactant, and (2) Compositions 5-10 included the same anionic surfactant in the concentrations shown in Table 3 below. The anionic surfactant included a sulfonate group. Compositions 4-10 did not include the first amine compound, but did include an abrasive, an organic phosphonic acid, an alkyl substituted benzotriazole, and the second amine compound, each of which were included in a fixed concentration. The test results are summarized in Table 3 below.

**Table 3**

| | Comp. 4 | Comp. 5 | Comp. 6 | Comp. 7 | Comp. 8 | Comp. 9 | Comp. 10 |
|---|---|---|---|---|---|---|---|
| Anionic Surfactant | None | 1X | 1.25X | 1.5X | 1.75X | 2X | 2.5X |
| Co RR (Å/min) | 363 | 384 | 168 | 127 | 100 | 62 | 76 |
| W RR (Å/min) | 27 | 77 | 12 | 14 | 17 | 29 | 12 |
| SiN RR (Å/min) | 288 | 290 | 370 | 364 | 357 | 226 | 295 |
| TEOS RR (Å/min) | 64 | 57 | 22 | 35 | 53 | 30 | 49 |

The results show that the addition of the anionic surfactant can effectively reduce the removal rate of cobalt with a significant reduction above a threshold amount of about 1X.

### Example 3

The removal rate for a variety of materials was measured by polishing blanket wafers with compositions 11-13. Compositions 11-13 were identical except that (1) Compositions 11-13 include the same first amine compound, an alkylamine with a 6-24 carbon alkyl chain in 0.33X, 0.5X, and 0.67X concentration, respectively. Compositions 11-13 did include an abrasive, an organic sulfonic acid, an alkyl substituted benzotriazole, and the second amine compound, each of which were included in a fixed concentration. The test results are summarized in Table 4 below.

**Table 4**

| | Comp. 11 | Comp. 12 | Comp. 13 |
|---|---|---|---|
| First Amine Compound | 0.33X | 0.5X | 0.67X |
| Co RR (Å/min) | 78 | 77 | 83 |
| W RR (Å/min) | 8 | 1 | 3 |
| SiN RR (Å/min) | 170 | 237 | 276 |
| TEOS RR (Å/min) | 56 | 57 | 59 |

The results show that the addition of the first amine compound can effectively reduce the removal rate of tungsten.

### Example 4

The removal rate for a variety of materials was measured by polishing blanket wafers with compositions 14-16. Compositions 14-16 were identical except that (1) Compositions 14-16 include the same anionic surfactant at 2X, 3X, and 4X, concentration respectively. The anionic surfactant included a sulfonate group. Compositions 14-16 did include an abrasive, an organic sulfonic acid, an alkyl substituted benzotriazole, and a second amine compound (an aminoalcohol), each at a fixed concentration. The test results are summarized in Table 5 below.

**Table 5**

| | Comp. 14 | Comp. 15 | Comp. 16 |
|---|---|---|---|
| Anionic Surfactant | 2X | 3X | 4X |
| Co RR (Å/min) | 83 | 36 | 37 |
| W RR (Å/min) | 53 | 42 | 67 |
| SiN RR (Å/min) | 165 | 65 | 20 |
| TEOS RR (Å/min) | 52 | 46 | 55 |

The results show that the anionic surfactant can be used to inhibit the removal of SiN.

### Example 5

The removal rate for a variety of materials was measured by polishing blanket wafers with compositions 17-20. Compositions 17-20 were identical except for the differences noted in Table 6. The azole containing compound is an alkyl substituted benzotriazole. Compositions 17-20 all include an abrasive, anionic surfactant including a sulfonate group, and a first amine compound, each at a fixed concentration. The first amine compound is an alkylamine including a 6-16 carbon alkyl chain.

The test results are summarized in Table 6 below.

**Table 6**

| | Comp. 17 | Comp. 18 | Comp. 19 | Comp. 20 |
|---|---|---|---|---|
| Organic Sulfonic Acid | 3.33X | 3.33X | 0 | 0 |
| Azole Containing Compound (wt. %) | 1.67X | 0 | 1.67X | 0 |
| Second Amine Compound (wt. %) | 2X | 0 | 2X | 0 |
| Organic Phosphonic Acid (wt. %) | 0 | 0 | 3.33X | 3.33X |
| Co RR (Å/min) | 57 | 94 | 56 | 171 |
| W RR (Å/min) | 3 | 9 | 10 | 9 |
| SiN RR (Å/min) | 169 | 160 | 222 | 132 |
| TEOS RR (Å/min) | 19 | 54 | 38 | 31 |
| Co SER (Å/min) | 0 | 5 | 0 | 6.3 |
| W SER (Å/min) | 0.1 | 2.4 | 0.3 | 2.8 |

The results show that Composition 17 and 19, including both the First and Second Amine compounds, effectively reduces the cobalt and the tungsten removal rates and SERs.

### Example 6

Cobalt blanket wafers were polished with the compositions described below. Surface roughness for the polished cobalt blanket wafers was measured by Atomic Force Microscopy (AFM) using an area scan to determine the Ra and Rq values. All the compositions included a fixed concentration of abrasive in addition to the listed components. The test results are summarized in Table 7 below.

**Table 7**

| | Composition 21 | Composition 22 (comparative) | Composition 23 (comparative) |
|---|---|---|---|
| Azole Containing Compound | 1.67X | 1.67X | N/A |
| Anionic Surfactant | 2X | N/A | 2X |
| Non-Ionic Surfactant | N/A | 2X | N/A |
| First Amine Compound | 0.33X | 0.33X | 0.33X |
| Second Amine Compound | 2X | 2X | 2X |
| Chlorinated Azole Containing Compound | N/A | N/A | 1.67X |
| Total Defect Counts on Cobalt | 25 | 182 | 428 |
| Rq | 6.4 Å | 68 Å | 53.6 Å |
| Ra | 2.8 Å | 45.7 Å | 32.6 Å |
| | | | |

Although only a few example embodiments have been described in detail above, those skilled in the art will readily appreciate that many modifications are possible in the example embodiments without materially departing from this invention. Accordingly, all such modifications are intended to be included within the scope of this disclosure as defined in the following claims.

### PREFERRED EMBODIMENTS

(1) A polishing composition comprising:
   at least one abrasive;
   at least one organic acid;
   at least one azole containing compound;
   a first amine compound comprising a 6-24 carbon alkyl chain;
   at least one anionic surfactant; and
   an aqueous solvent;
   optionally, a pH adjuster.
(2) The polishing composition of (1), further comprising a second amine compound, wherein the second amine compound comprises an aminoalcohol.
(3) The polishing composition of (1), wherein the at least one abrasive is selected from the group consisting of alumina, silica, titania, ceria, zirconia, co-formed products of alumina, silica, titania, ceria, or zirconia, coated abrasives, surface modified abrasives, and mixtures thereof.
(4) The polishing composition of (1), wherein the at least one abrasive is in an amount of from about 0.01% to about 25% by weight of the composition.
(5) The polishing composition of (1), wherein the organic acid may be selected from the group consisting of a carboxylic acid, an amino acid, an organic sulfonic acid, an organic phosphonic acid or mixtures thereof.
(6) The polishing composition of (1), wherein the at least one organic acid is selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic acid, m-xylene-4-sulfonic acid, poly(4-styrenesulfonic acid), polyanetholesulfonic acid, p-toluenesulfonic acid, trifluoromethane-sulfonic acid, ethyl phosphoric acid, cyanoethyl phosphoric acid, phenyl phosphoric acid, vinyl phosphoric acid, poly(vinylphosphonic acid), 1-hydroxyethane-1,1-diphosphonic acid, nitrilotri(methylphosphonic acid), diethylenetriaminepentakis (methylphosphonic acid), N,N,N'N'-ethylenediaminetetrakis(methylene phosphonic acid), n-hexylphosphonic acid, benzylphosphonic acid, phenylphosphonic acid, salts thereof, and mixtures thereof.
(7) The polishing composition of (1), wherein the at least one organic acid is in an amount of from about 0.01% to about 1% by weight of the composition.
(8) The polishing composition of (1), wherein the anionic surfactant is selected from the group consisting of carboxylic acid salts, sulfonic acid salts, sulfate salts, phosphate salts, phosphonate salts, sarcosinate salts, or mixtures thereof.
(9) The polishing composition of (1), wherein the anionic surfactant comprises a sulphonate group.
(10) The polishing composition of (1), wherein the at least one anionic surfactant is selected from the group consisting of an alkyl sulphonate, an alkylaryl sulphonate, a polyoxyethylene alkyl ether sulphonate, a polyoxyethylene aryl alkyl ether sulphonate, a polyoxyethylene nonylaryl ether sulphonate, a polyoxyethylene nonylphenyl ether sulphonate, and mixtures thereof.
(11) The polishing composition of (1), wherein the anionic surfactant is in an amount of from about 0.001% to about 0.5% by weight of the composition.
(12) The polishing composition of (1), wherein the at least one azole is selected from the group consisting of heterocyclic azoles, substituted or unsubstituted triazoles, substituted or unsubstituted tetrazoles, substituted or unsubstituted diazoles, and substituted or unsubstituted benzothiazoles.
(13) The polishing composition of (1), wherein the at least one azole is selected from the group consisting of tetrazole, benzotriazole, tolyltriazole, methyl benzotriazole, ethyl benzotriazole, propyl benzotriazole, butyl benzotriazole, pentyl benzotriazole, hexyl benzotriazole, dimethyl benzotriazole, chloro benzotriazole, dichloro benzotriazole, chloromethyl benzotriazole, chloroethyl benzotriazole, phenyl benzotriazole, benzyl benzotriazole, aminotriazole, aminobenzimidazole, pyrazole, imidazole, aminotetrazole, adenine, benzimidazole, thiabendazole, 1,2,3-triazole, 1,2,4-triazole, 1-hydroxybenzotriazole, 2-methylbenzothiazole, 2-aminobenzimidazole, 2-amino-5-ethyl-1,3,4-thiadiazole, 3,5-diamino-1,2,4-triazole, 3-amino-5-methylpyrazole, 4-amino-4H-1,2,4-triazole, aminotetrazole, tetrazole, phenyltetrazole, phenyltetrazole-5-thiol, and combinations thereof.
(14) The polishing composition of (1), wherein the at least one azole is in an amount of from about 0.001% to about 0.5% by weight of the composition.
(15) The polishing composition of (1), wherein the first amine compound has a 6-18 carbon alkyl chain.
(16) The polishing composition of (1), wherein the first amine compound is in an amount of from about 0.0005% to about 0.5% by weight of the composition.
(17) The polishing composition of (2), wherein the second amine compound is a β-hydroxyl-alkylamine or a derivative thereof.
(18) The polishing composition of (2), wherein the second amine compound is selected from the group consisting of ethanolamine, diethanolamine, 2-amino-3-hexanol, 2-amino-2-methyl-3-hexanol, 2-amino-2-methyl-3-heptanol, 2-amino-4-ethyl-3-octanol, 2-amino-3-heptanol,2-amino-1-phenylbutanol, 3-Amino-4-octanol, 2-Dimethylamino-2-methyl-1-propanol, 2-Amino-1-butanol, 2-amino-2-ethylpropanediol,2-Amino-2-methyl-1-propanol, 2-Methylamino-2-methyl-1-propanol, 1-amino-2-propanol, bis(2-hydroxypropyl)amine, tris(2-hydroxypropyl)amine, bis(2-hydroxyethyl)amine, tris(2-hydroxyethyl)amine, 2-(2-aminoethoxy)ethanol, or mixtures thereof.
(19) The polishing composition of (1), wherein the second amine compound is in an amount of from about 0.001% to about 0.5% by weight of the composition.
(20) The polishing composition of (1), wherein the pH of the composition is between about 1 to about 7.
(21) The polishing composition of (1), further comprising:
   an organic solvent in an amount of from about 0.01% to about 5% by weight of the composition.
(22) The polishing composition of (21), wherein the organic solvent is selected from the group consisting of ethanol, 1-propanol, 2-propanol, n-butanol, propylene glycol, 2-methoxyethanol, 2-ethoxyethanol, propylene glycol propyl ether, ethylene glycol, and any combinations thereof.
(23) The polishing composition of (1), wherein the polishing composition does not include an oxidizing agent.
(24) A polishing composition comprising:
   at least one abrasive;
   at least one organic acid;
   at least one azole containing compound;
   a first amine compound comprising a 6-24 carbon alkyl chain;
   a second amine compound comprising an aminoalcohol;
   an aqueous solvent;
   and optionally, a pH adjuster.
(25) A polishing composition comprising:
   at least one abrasive;
   at least one organic acid;
   an anionic surfactant;
   at least one azole containing compound;
   a first amine compound comprising a 6-24 carbon alkyl chain;
   a second amine compound comprising an aminoalcohol;
   an aqueous solvent; and
   optionally, a pH adjuster.
(26) A method of polishing a substrate, comprising the steps of:
   applying the polishing composition of any of (1)-(25) to a substrate comprising a metal on a surface of the substrate; and
   bringing a pad into contact with the surface of the substrate and moving the pad in relation to the substrate.
(27) The method of polishing a substrate of (26), wherein the metal is at least one of cobalt and tungsten.

## Claims

1. A polishing composition comprising:
at least one abrasive;
at least one organic acid;
at least one azole containing compound;
at least one first amine compound comprising a 6-24 carbon alkyl chain;
optionally at least one anionic surfactant; and
at least one second amine compound comprising an aminoalcohol;
an aqueous solvent;
optionally, a pH adjuster.

2. The polishing composition of claim 1, wherein the at least one abrasive is selected from the group consisting of alumina, silica, titania, ceria, zirconia, co-formed products of alumina, silica, titania, ceria, or zirconia, coated abrasives, surface modified abrasives, and mixtures thereof, or wherein the at least one abrasive is in an amount of from about 0.01% to about 25% by weight of the composition.

3. The polishing composition of claim 1, wherein the organic acid may be selected from the group consisting of a carboxylic acid, an amino acid, an organic sulfonic acid, an organic phosphonic acid or mixtures thereof, or wherein the at least one organic acid is selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic acid, m-xylene-4-sulfonic acid, poly(4-styrenesulfonic acid), polyanetholesulfonic acid, p-toluenesulfonic acid, trifluoromethane-sulfonic acid, ethyl phosphoric acid, cyanoethyl phosphoric acid, phenyl phosphoric acid, vinyl phosphoric acid, poly(vinylphosphonic acid), 1-hydroxyethane-1,1-diphosphonic acid, nitrilotri(methylphosphonic acid), diethylenetriaminepentakis (methylphosphonic acid), N,N,N'N'-ethylenediaminetetrakis(methylene phosphonic acid), n-hexylphosphonic acid, benzylphosphonic acid, phenylphosphonic acid, salts thereof, and mixtures thereof.

4. The polishing composition of claim 1, wherein the at least one organic acid is in an amount of from about 0.01% to about 1% by weight of the composition.

5. The polishing composition of claim 1, wherein the anionic surfactant is selected from the group consisting of carboxylic acid salts, sulfonic acid salts, sulfate salts, phosphate salts, phosphonate salts, sarcosinate salts, or mixtures thereof,
preferably wherein the anionic surfactant comprises a sulphonate group, or wherein the at least one anionic surfactant is selected from the group consisting of an alkyl sulphonate, an alkylaryl sulphonate, a polyoxyethylene alkyl ether sulphonate, a polyoxyethylene aryl alkyl ether sulphonate, a polyoxyethylene nonylaryl ether sulphonate, a polyoxyethylene nonylphenyl ether sulphonate, and mixtures thereof.

6. The polishing composition of claim 1, wherein the anionic surfactant is in an amount of from about 0.001% to about 0.5% by weight of the composition.

7. The polishing composition of claim 1, wherein the at least one azole is selected from the group consisting of heterocyclic azoles, substituted or unsubstituted triazoles, substituted or unsubstituted tetrazoles, substituted or unsubstituted diazoles, and substituted or unsubstituted benzothiazoles, or wherein the at least one azole is selected from the group consisting of tetrazole, benzotriazole, tolyltriazole, methyl benzotriazole, ethyl benzotriazole, propyl benzotriazole, butyl benzotriazole, pentyl benzotriazole, hexyl benzotriazole, dimethyl benzotriazole, chloro benzotriazole, dichloro benzotriazole, chloromethyl benzotriazole, chloroethyl benzotriazole, phenyl benzotriazole, benzyl benzotriazole, aminotriazole, aminobenzimidazole, pyrazole, imidazole, aminotetrazole, adenine, benzimidazole, thiabendazole, 1,2,3-triazole, 1,2,4-triazole, 1-hydroxybenzotriazole, 2-methylbenzothiazole, 2-aminobenzimidazole, 2-amino-5-ethyl-1,3,4-thiadiazole, 3,5-diamino-1,2,4-triazole, 3-amino-5-methylpyrazole, 4-amino-4H-1,2,4-triazole, aminotetrazole, tetrazole, phenyltetrazole, phenyl-tetrazole-5-thiol, and combinations thereof.

8. The polishing composition of claim 1, wherein the at least one azole is in an amount of from about 0.001% to about 0.5% by weight of the composition.

9. The polishing composition of claim 1, wherein
(i) the first amine compound has a 6-18 carbon alkyl chain,
(ii) wherein the first amine compound is in an amount of from about 0.0005% to about 0.5% by weight of the composition, or
(iii) wherein the second amine compound is a β-hydroxyl-alkylamine or a derivative thereof.

10. The polishing composition of claim 1, wherein the second amine compound is selected from the group consisting of ethanolamine, diethanolamine, 2-amino-3-hexanol, 2-amino-2-methyl-3-hexanol, 2-amino-2-methyl-3-heptanol, 2-amino-4-ethyl-3-octanol, 2-amino-3-heptanol,2-amino-1-phenylbutanol, 3-Amino-4-octanol, 2-Dimethylamino-2-methyl-1-propanol, 2-Amino-1-butanol, 2-amino-2-ethylpropanediol,2-Amino-2-methyl-1-propanol, 2-Methylamino-2-methyl-1-propanol, 1-amino-2-propanol, bis(2-hydroxypropyl)amine, tris(2-hydroxypropyl)amine, bis(2-hydroxyethyl)amine, tris(2-hydroxyethyl)amine, 2-(2-aminoethoxy)ethanol, or mixtures thereof.

11. The polishing composition of claim 1, wherein the second amine compound is in an amount of from about 0.001% to about 0.5% by weight of the composition.

12. The polishing composition of claim 1, wherein the pH of the composition is between about 1 to about 7.

13. The polishing composition of claim 1, further comprising:
an organic solvent in an amount of from about 0.01% to about 5% by weight of the composition,
preferably wherein the organic solvent is selected from the group consisting of ethanol, **1-**propanol, 2-propanol, n-butanol, propylene glycol, 2-methoxyethanol, 2-ethoxyethanol, propylene glycol propyl ether, ethylene glycol, and any combinations thereof.

14. The polishing composition of claim 1, wherein the polishing composition does not include an oxidizing agent.

15. A method of polishing a substrate, comprising the steps of:
applying the polishing composition of any of claims 1 to 13 to a substrate comprising a metal on a surface of the substrate; and
bringing a pad into contact with the surface of the substrate and moving the pad in relation to the substrate,
preferably, wherein the metal is at least one of cobalt and tungsten.
